# EUROPÄISCHE PATENTSCHRIFT

(11) **EP 0 687 013 B1**
(45) Veröffentlichungstag und Bekanntmachung des Hinweises auf die Patenterteilung: **26.09.2001**
(21) Anmeldenummer: 95106863.4
(22) Anmeldetag: 05.05.1995
(51) Int. Cl.: H01L 29/73, H01L 29/732, H01L 21/331

(54) **Bipolartransistor und Herstellungsverfahren**
Bipolar transistor and method of manufacturing the same
Transistor bipolaire et procédé de fabrication

(30) Priorität: 25.05.1994 DE 4418206
(43) Veröffentlichungstag der Anmeldung: 13.12.1995
(73) Patentinhaber: Infineon Technologies AG, 81669 München (DE)
(72) Erfinder: Mahnkopf, Reinhard, Dr., D-81479 München (DE); vom Felde, Andreas, Dr., Wappinger Falls, N.Y.12590 (US)
(74) Vertreter: Zedlitz, Peter, Dipl.-Inf.

(56) Entgegenhaltungen:
- EP-A- 0 476 380
- EP-A- 0 623 951
- US-A- 4 868 624
- INTERNATIONAL ELECTRON DEVICES MEETING 1994. TECHNICAL DIGEST (CAT. NO.94CH35706), PROCEEDINGS OF 1994 IEEE INTERNATIONAL ELECTRON DEVICES MEETING, SAN FRANCISCO, CA, USA, 11-14 DEC. 1994, ISBN 0-7803-2111-1, 1994, NEW YORK, NY, USA, IEEE, USA, Seiten 743-746, ARNBORG T 'Modelling and simulation of high speed, high voltage bipolar SOI transistor with fully depleted collector'
- PROCEEDINGS OF THE 6TH INTERNATIONAL SYMPOSIUM ON POWER SEMICONDUCTOR DEVICES AND ICS. ISPSD '94 (IEEE CAT. NO.94CH3377-9), PROCEEDINGS OF ISPSD'94 INTERNATIONAL SYMPOSIUM ON POWER SEMICONDUCTOR DEVICES AND IC'S, DAVOS, SWITZERLAND, 31 MAY-2 JUNE 199, ISBN 3-89191-784-8, 1994, KONSTANZ, GERMANY, HARTUNG-GORRE VERLAG, GERMANY, Seiten 113-115, LITWIN A ET AL 'Compact very high voltage CMOS compatible bipolar silicon-on-insulator transistor'
- PATENT ABSTRACTS OF JAPAN vol. 013 no. 216 (E-760) ,19.Mai 1989 & JP-A-01 028958 (HITACHI LTD) 31.Januar 1989,
- ESSDERC93, 23rd European Solid State device research conference 13-16th september 1993, Grenoble (France) late night session 14 september 1993 A Litwin et al

## Beschreibung

Die vorliegende Erfindung betrifft einen Bipolartransistor auf SOI-Substrat und ein zugehöriges Herstellungsverfahren.

Ein CBiCMOS-Prozeß dient der gleichzeitigen Herstellung folgender aktiver Bauelemente: npn-Bipolartransistoren, pnp-Bi-polartransistoren, n-MOS-Transistoren und p-MOS-Transistoren. Von großem technischem und wirtschaftlichem Interesse ist die Realisierung eines komplementären BiCMOS-Prozesses (CBiCMOS) dann, wenn es gelingt, die beiden folgenden Forderungen gleichzeitig zu erfüllen:
Erstens: Der CBiCMOS-Prozeß darf nur unwesentlich komplexer, d. h. aufwendiger, sein, als der reine CMOS-Prozeß.
Zweitens: Die Bauelemente müssen sehr gute Funktionseigenschaften (Performance) aufweisen.

Bei einer Realisierung der vier verschiedenen Transistortypen auf einem normalen Substrat aus Bulk-Silizium bzw. auf dicken SOI-Substraten (Silizium-Nutzschicht, sogenanntes Body-Silizium, dicker als 1 µm) werden die Bipolartransistoren vertikal aufgebaut. Bei angestrebter guter Performance ist allerdings der Prozeßaufwand sehr hoch. Auf dünnen SOI-Substraten mit einer Body-Siliziumschicht von weniger als 0,2 um Dicke kann ein CBiCMOS-Prozeß sehr viel einfacher realisiert werden. Bei allen bekannten Verfahren sind die Bipolartransistoren wie die MOSFETs lateral aufgebaut. Der strukturelle Aufbau beider Transistortypen ähnelt sich sehr; die Komplexität des Herstellungsverfahrens ist relativ niedrig. Ein derartiges Prozeßkonzept ist z. B. in der Veröffentlichung von S. Parke e. a. "A Versatile, SOI BiCMOS Technology with Complementary Lateral BJT's" in IEDM 92, 453 - 456 (1992) beschrieben. Außerdem gibt es Konzepte für einen komplementären Bipolarprozeß auf dünnem Body-Silizium, wie z. B. von R.

Dekker e. a. in IEDM 93, 75 - 78 (1993), die sich im Prinzip zu einem vollständigen CBiCMOS-Prozeß erweitern lassen. Ein lateraler Aufbau der Bipolartransistoren hat jedoch im Gegensatz zum vertikalen Aufbau einige grundsätzliche Nachteile, die die Funktionseigenschaften drastisch verschlechtern. Der elektrische Anschluß des relativ schmalen Basisbereiches zwischen Emitter und Kollektor kann nur über die Transistor-Längsseiten erfolgen, was einen hohen Basiswiderstand zur Folge hat. Für einen akzeptablen Basiswiderstand müssen die Transistoren mit kurzen Emitterlängen ausgeführt und parallel geschaltet werden. Das erhöht den Flächenbedarf. Aufgrund der kleinen effektiven Emitterflächen der lateralen Transistoren ist die Stromergiebigkeit dieser Ausführungsformen sehr gering. Für einen akzeptablen Strom ergibt sich wieder die Notwendigkeit, mehrere Transistoren parallel zu schalten, was den Flächenbedarf ebenfalls erheblich erhöht. Wenn wegen der Kompatibilität zum CMOS-Prozeß auf einen Polysilizium-Emitter verzichtet wird, um den Aufwand gering zu halten, ist die Einstellung der Stromverstärkung der Transistoren wegen des Fortfalls des Polyemitter-Effektes erschwert.

In der EP 0 476 380 A1 sind ein vertikaler NPN-Transistor und ein zugehöriges Herstellungsverfahren beschrieben, bei dem auf einem SOI-Substrat in der Body-Siliziumschicht eine Mesa geätzt wird. In dieser Mesa werden übereinander ein n-dotierter Kollektorbereich und ein p-dotierter Basisbereich implantiert. Auf die Oberseite des Basisbereiches werden eine Oxidschicht mit einer Öffnung im Bereich des herzustellenden Emitter-Basis-Überganges und darauf eine Polysiliziumschicht abgeschieden und strukuriert. Zur Ausbildung eines Emitters wird die Polysiliziumschicht n-leitend dotiert. Als Stromzuführungen zu dem Basisbereich und dem Kollektorbereich sind lateral angrenzende dotierte Bereiche ausgebildet.

Aufgabe der vorliegenden Erfindung ist es, einen CMOS-kompatiblen Bipolartransistor auf SOI-Substrat anzugeben, der bei einfachster Prozeßführung alle eingangs genannten Nachteile vermeidet und dabei beste Funktionsfähigkeit (hohe Performance) gewährleistet.

Diese Aufgabe wird mit dem Bipolartransistor mit den Merkmalen des Anspruches 1 bzw. mit dem Verfahren zur Herstellung mit den Merkmalen des Anspruches 9 gelöst. Jeweilige Ausgestaltungen ergeben sich aus den abhängigen Ansprüchen.

Der erfindungsgemäße Bipolartransistor ist vertikal und kompatibel zu einem lateral orientierten Gesamtprozeß konzipiert. Es folgt eine Beschreibung des erfindungsgemäßen Transistors und eines zugehörigen Herstellungsverfahrens anhand der Figuren 1 bis 6.
- Figuren 1 bis 4: zeigen Zwischenprodukte des erfindungsgemäßen Bauelementes im Querschnitt nach verschiedenen Schritten des Herstellungsverfahrens.
- Figur 5: zeigt eine Ausführungsform des erfindungsgemäßen Bauelementes im Querschnitt.
- Figur 6: zeigt eine Aufsicht auf das Bauelement mit Angabe der die Struktur festlegenden Begrenzungen.

Bei dem erfindungsgemäßen Bauelement sind in einer dünnen Body-Siliziumschicht eines SOI-Substrates übereinander ein Kollektorbereich und ein Basisbereich durch Implantationen ausgebildet. In dem Basisbereich ist ein Emitterbereich vorzugsweise durch Ausdiffusion von Dotierstoff aus einer darauf aufgebrachten und dotierten Polysiliziumschicht hergestellt. Für den elektrischen Anschluß befinden sich laterale dotierte Bereiche mit jeweils dem Leitungstyp der betreffenden anzuschließenden Schicht. Die Kontaktierung erfolgt von der Oberseite. Es folgt eine nähere Beschreibung der Struktur dieses Bauelementes anhand eines Herstellungsverfahrens.

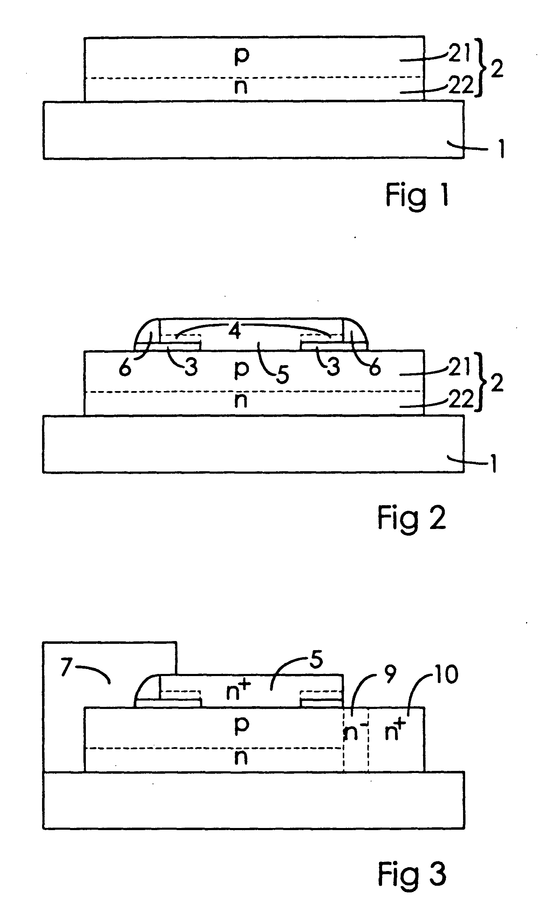

Es wird ausgegangen von einem SOI-Substrat, bei dem auf einem Grundkörper z. B. aus Silizium eine Isolationsschicht 1 (s. Figur 1) z. B. aus einem Oxid und darauf eine dünne kristalline Siliziumschicht 2 aufgebracht sind. Die dünne Siliziumschicht 2 ist z. B. etwa 0,2 um dick und wird im folgenden als Body-Siliziumschicht bezeichnet. Diese Schichtdicke ist geeignet für die Herstellung von CMOS-Transistoren auf demselben SOI-Substrat. Zu diesem Zweck werden zunächst die für die einzelnen Transistoren vorgesehenen Bereiche gegeneinander isoliert und ggf. eine Grunddotierung für die Ausbildung der Kanalbereiche der MOSFETs hergestellt. Die Isolation der für die einzelnen Transistoren vorgesehenen Bereiche kann z. B. durch LOCOS, d. h. eine lokal begrenzte Oxidierung der Siliziumschicht, oder durch Ätzen von Mesas erfolgen. Bei dem hier beschriebenen Beispiel wird die Darstellung auf einen in einer Mesa hergestellten Bipolartransistor beschränkt. Unabhängig von der Herstellung von MOSFETs in demselben Substrat beträgt die Dicke der Body-Siliziumschicht 2 bei zweckmäßigen Ausführungsformen des erfindungsgemäßen Bipolartransistors höchstens 0,6 um. Je nach spezifischen Anforderungen beträgt die Dicke der Body-Siliziumschicht z. B. nur höchstens 0,4 µm oder nur höchstens 0,2 µm. Der Bipolartransistor läßt sich aber auch in einer 1 um dicken Siliziumschicht realisieren.

Unter Verwendung von Maskentechnik, wie sie bei der Herstellung von Halbleiterbauelementen, insbesondere beim CMOS-Prozeß in Silizium üblich ist, werden in dem für den Bipolartransistor vorgesehenen Bereich Implantierungen zur Ausbildung eines Kollektorbereichs 22 und darüber eines Basisbereichs 21 vorgenommen. Der implantierte Dotierstoff wird dabei jeweils entsprechend dem vorgesehenen Vorzeichen des Leitungstyps gewählt. In den Figuren wird als Beispiel die Herstellung eines npn-Transistors beschrieben. Der wesentliche Vorteil des hier beschriebenen Verfahrens besteht darin, daß es als CBiCMOS-Prozeß einsetzbar ist und also insbesondere damit auf demselben SOI-Substrat auch komplementäre pnp-Transistoren hergestellt werden können. Für die Implantierung von Kollektor- und Basisbereich dieser komplementären Transistoren ist entsprechend eine weitere Maske vorzusehen. Der unterste implantierte Bereich wird im folgenden durchgehend als Kollektorbereich bezeichnet; grundsätzlich kann aber der unterste dotierte Bereich des Transistors auch als Emitterbereich vorgesehen sein oder in einer Schaltung als Emitterbereich betrieben werden.

Als nächstes wird entsprechend Figur 2 eine Oxidschicht 3 ganzflächig aufgebracht. Diese Oxidschicht 3 dient bei gleichzeitiger Herstellung von MOSFETs als Gate-Oxid und wird dann in einer dafür geeigneten Dicke aufgebracht. Ggf. wird eine dünne Polysiliziumschicht 4 (sog. Split-Poly) auf diese Oxidschicht 3 aufgebracht. Im Bereich des herzustellenden Emitters wird die Oxidschicht 3 in einem Teil der Oberfläche des Basisbereichs 21 vollständig entfernt, so daß die Oberfläche dieses Basisbereichs 21 freiliegt und die restliche Oxidschicht 3 z. B. wie in Figur 2 dargestellt diesen freigelegten Bereich rings umschließt. Die zum teilweisen Entfernen der Oxidschicht 3 verwendete Maskentechnik wird bevorzugt nicht direkt auf der Oxidschicht 3 angewendet, sondern auf der darauf aufgebrachten dünnen Polysiliziumschicht 4, weil bei Anwendung als CBiCMOS-Prozeß die Maskentechnik direkt auf dem Gate-Oxid die Eigenschaften der MOSFETs negativ beeinflussen könnte. Grundsätzlich kann die Oxidschicht 3 bei dem erfindungsgemäßen Bipolartransistor auch ganz weggelassen sein.

Nach diesem Verfahrensschritt kann wahlweise die Dotierung des Kollektorbereichs 22 mittels einer sogenannten Podest-Implantation angehoben oder abgesenkt werden. Diese Implantierung erfolgt in dem Bereich der Öffnung der Oxidschicht 3. Werden gleichzeitig npn- und pnp-Transistoren hergestellt, sind für diese jeweiligen Podest-Implantationen zusätzliche Maskentechniken notwendig. Nachfolgend wird eine Polysiliziumschicht 5 abgeschieden, die ggf. auch das Polysilizium der Gate-Elektrode bei den MOSFETs bildet. Diese Polysiliziumschicht 5 gehört zu einem bevorzugten Ausführungsbeispiel des Bipolartransistors und bildet hier die Emitteranschlußschicht. Diese Polysiliziumschicht bedeckt den zuvor von der Oxidschicht 3 befreiten Anteil des Basisbereichs 21. Nach dem Strukturieren dieser Polysiliziumschicht 5 können die in Figur 2 eingezeichneten Spacer 6 an den Rändern der Polysiliziumschicht 5 hergestellt werden. Diese Spacer können z. B. aus Oxid sein und mit anisotropem Rückätzen einer zuvor ganzflächig aufgebrachten Oxidschicht hergestellt werden. Alternativ können auch vertikale Anteile einer ganzflächig aufgebrachten Schicht an den Rändern der Polysiliziumschicht 5 als Spacer fungieren. Die Bezeichnung "Spacer" wird hier und in den Ansprüchen verallgemeinernd auch für derartige vertikale Anteile einer ganzflächigen Schicht verwendet.

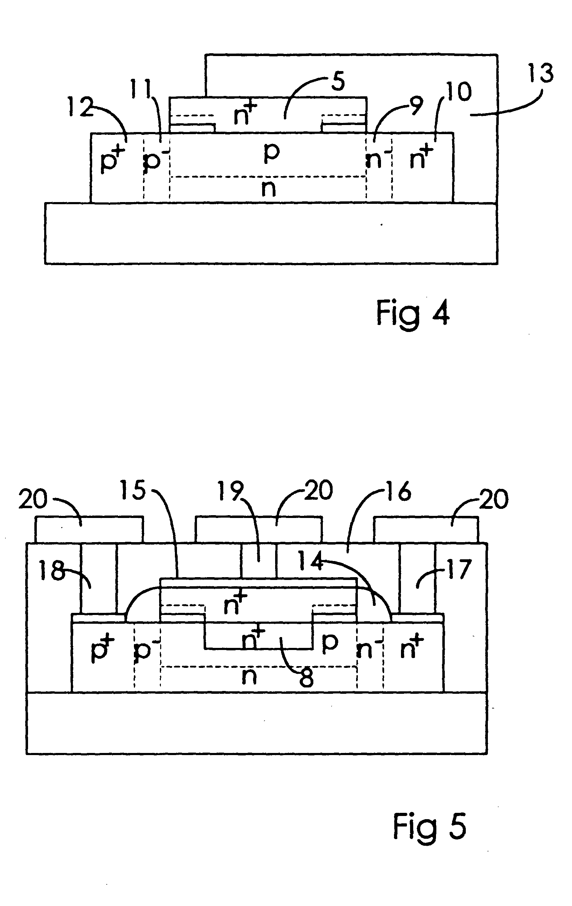

Es werden dann nacheinander eine Lackmaske aufgebracht und entfernt und eine weitere Lackmaske aufgebracht und entfernt. Diese Masken dienen der Implantation von Dotierstoff für jeweils einen der Leitungstypen. Die in Figur 3 dargestellte erste Implantationsmaske 7 läßt bei diesem Beispiel die für n-Leitung vorgesehenen Bereiche frei. Das sind bei diesem npn-Transistor der für den Emitter vorgesehene Bereich der Polysiliziumschicht 5 und der für die Ausbildung von Anschlußbereichen für den Kollektorbereich 22 vorgesehene laterale Bereich. Wenn auch pnp-Transistoren hergestellt werden, deckt diese Implantationsmaske 7 bei den pnp-Transistoren die komplementären Bereiche ab und läßt die für die Ausbildung der Anschlußbereiche der Basis vorgesehenen Bereiche frei. Für die Implantierung für die entgegengesetzte Leitfähigkeit wird dann die in Figur 4 dargestellte Implantationsmaske 13, die jeweils die komplementären Bereiche frei läßt, aufgebracht. Die Reihenfolge von n- und p-Dotierung ist im Prinzip freigestellt. Bei dem hier dargestellten Ausführungsbeispiel entsprechend der Figur 3 wird die Implantierung zunächst für n-Leitung vorgenommen. Dabei wird die Polysiliziumschicht 5, die auch den Anschlußbereich für den Emitter bildet, n⁺-leitend dotiert. In einem nachfolgenden Temperschritt wird die Ausdiffusion von Dotierstoff aus der Polysiliziumsschicht 5 in den Basisbereich bewirkt, so daß ein Emitterbereich 8 wie in Figur 5 eingezeichnet gebildet wird. Durch den Spacer abgegrenzt erhält man außerdem den hoch n-leitend dotierten Anschlußbereich 10 für den Kollektorbereich. Es kann dann der Spacer in dem nicht von der Maske 7 bedeckten Bereich z. B. naßchemisch zusammen mit dem darunter befindlichen Anteil der Oxidschicht 3 weggeätzt werden und eine erneute Implantierung für denselben Leitungstyp vorgenommen werden, so daß der niedriger dotierte Übergangsbereich 9 zwischen dem Kollektorbereich und dem dafür vorgesehenen Anschlußbereich 10 ausgebildet wird. In für MOSFETs vorgesehenen Bereichen können gleichzeitig damit die betreffenden Übergangsbereiche zwischen Gate und Drain, durch die ein LDD (Lightly Doped Drain) ausgebildet wird, hergestellt werden. Es ist aber grundsätzlich auch möglich, auf die Spacer 6 und auf die Herstellung der Übergangsbereiche zu verzichten.

Nach dem Entfernen der Maske 7 wird die komplementäre Maske 13 aufgebracht, die einer Implantation von Dotierstoff für das entgegengesetzte Vorzeichen der Leitfähigkeit dient. Damit erhält man den in diesem Beispiel hoch p-leitend dotierten Anschlußbereich 12 für den Basisbereich (s. Figur 4). Nach dem Entfernen des jetzt freiliegenden Anteils der Spacer und dem darunter befindlichen Anteil der Oxidschicht 3 kann eine weitere Implantierung vorgenommen werden, die einen entsprechend niedriger dotierten Übergangsbereich 11 zwischen diesem Anschlußbereich 12 und dem Basisbereich ausbildet. Gleichzeitig können LDDs für komplementäre MOSFETs hergestellt werden. Die Struktur dieser mit LDDs versehenen MOSFETs ist im Prinzip bekannt und wird daher hier nicht anhand von Figuren beschrieben. Die Grenzfläche zwischen der Polysiliziumschicht 5 und der Basisschicht 21, d. h. zwischen dem Emitterbereich und dem zugehörigen Anschlußbereich des fertigen Bauelementes, ist bei diesem Beispiel etwa 0,8 um x 0,8 µm groß.

Zur Fertigstellung des Bauelementes sind dann noch die elektrischen Anschlüsse anzubringen. Dabei können weitere Spacer 14 wie in Figur 5 dargestellt an den Rändern der Polysiliziumschicht 5 hergestellt werden. Diese weiteren Spacer 14 können z. B. ein Oxid sein (z. B. SiO₂), das zunächst ganzflächig aufgebracht und dann anisotrop rückgeätzt wird. Unter Verwendung dieser weiteren Spacer 14 als Abstandshalter wird dann eine Silizidschicht 15 auf den Oberseiten der Anschlußbereiche aufgebracht (z. B. mittels des sog. Salicide-Prozesses, bei dem z. B. Titan aufgesputtert wird, das mit dem Silizium zu niederohmigem TiSi₂ reagiert). Nachdem die gesamte Oberseite z. B. mit einem Dielektrikum 16 planarisiert ist, werden für den elektrischen Anschluß Kontaktlöcher darin geätzt und mit Metall gefüllt, so daß die Kontakte 17, 18, 19 für den elektrischen Anschluß von Kollektor, Basis und Emitter damit hergestellt sind. Die erste Metallisierungsebene kann dann auf die Oberseite aufgebracht werden, was in Figur 5 mit den Anschlußflächen 20 oder Leiterbahnen dargestellt ist.

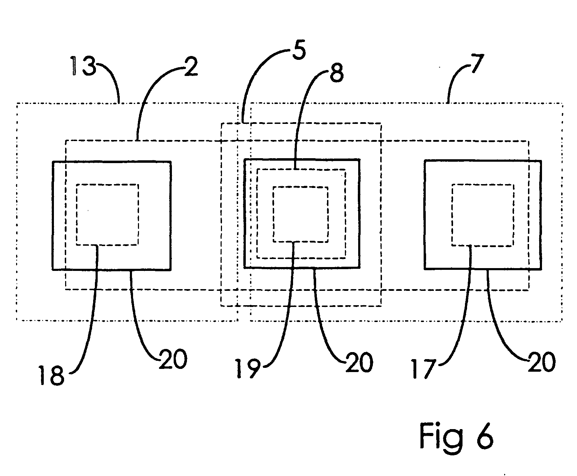

In Figur 6 sind die für die Struktur des Bauelementes maßgeblichen Umrandungen in einer Aufsicht auf den Bipolartransistor dargestellt. Gestrichelte Linien geben dabei verdeckte Konturen an. Strichpunktierte Linien, bei denen jeweils ein Punkt auf einen Strich folgt, geben die äußeren Umrandungen der Öffnung verwendeter Masken an. In Figur 6 sind in der Aufsicht die Berandungen der Anschlußflächen 20 der ersten Metallisierungsebene erkennbar. Die Kontakte 17, 18, 19, die hier vereinfacht mit quadratischem Querschnitt dargestellt sind, sind als verdeckte Konturen erkennbar. Die seitlichen Berandungen des ausdiffundierten Emitterbereichs 8, der Polysiliziumschicht 5 und der durch die Body-Siliziumschicht 2 gebildeten Mesa sind ebenfalls als verdeckte Konturen eingezeichnet. Die für die Implantationen der Anschlußbereiche verwendeten Masken 7, 13 sind jeweils strichpunktiert eingezeichnet. Die von diesen nacheinander aufgebrachten Masken jeweils bedeckten Bereiche können auch aneinandergrenzen oder sich überschneiden. Der Emitterkontakt 19 kann die gesamte Oberfläche des Emitterbereiches 8 bedecken und sogar etwas auf das seitlich angrenzende Oxid der Oxidschicht 3 hinausragen. Diese Oxidschicht 3 ist zwischen der Kontur des Emitterbereiches 8 und der Kontur der Polysiliziumschicht 5 auf der Unterseite der Polysiliziumschicht 5 vorhanden. Statt der die Darstellung vereinfachenden separaten Anschlußflächen 20 können auf die Kontakte 17, 18, 19 auch Anteile von Leiterbahnen aufgebracht sein.

Bei vorteilhaften Ausführungsformen wird der Kollektorbereich 22 zwischen dem Basisbereich 21 und der Isolierschicht 1 mit einer so niedrigen Dotierung versehen, daß beim Anlegen der für die vorgesehene Betriebsweise des Transistors erforderlichen elektrischen Potentiale der Kollektorbereich 22 im wesentlichen vollständig an Ladungsträgern verarmt ist. Eine vollständige Verarmung des Kollektorbereiches 22 bereits im Zustand ohne angelegtes äußeres Potential wird erreicht, wenn das Produkt aus dem Quadrat der Dicke des Kollektorbereichs 22 und der Dotierungsdichte höchstens 8 · 10⁶ cm⁻¹ beträgt. Bei derartigen Ausführungsformen kann die geringe Dicke der Body-Siliziumschicht 2 unabhängig von der Ausführung im Rahmen eines CMOS-Prozesses eine Rolle spielen.

Das beschriebene Herstellungsverfahren für die Bipolartransistoren ist voll kompatibel mit der Herstellung der CMOSFETs. Gegenüber einem reinen CMOS-Prozeß beträgt bei diesem komplementären CBiCMOS-Prozeß der Mehraufwand drei Fototechniken, nämlich die Masken für die Kollektor- und Basisimplantierungen jeweils für npn-Transistoren und pnp-Transistoren getrennt und die Maske für die Öffnung des für den Emitter vorgesehenen Bereiches in der Gate-Oxidschicht. Im Unterschied zu den aus der Literatur bekannten CBiCMOS-Prozessen mit lateralen Bipolartransistoren wird ein Fotomaskenschritt weniger benötigt. Im Gegensatz zum CMOS-kompatiblen lateralen Bipolartransistor hat der erfindungsgemäße vertikal-laterale Bipolartransistor vor allem die nachfolgenden grundsätzlichen Vorteile:
Der elektrische Anschluß an die Basis wird lateral zur Schichtstruktur an den Breitseiten des Transistors zugeführt, so daß der Basis-Widerstand sehr niedrig ist.
Die vergleichsweise große Emitterfläche gewährleistet eine hohe Stromergiebigkeit.
Bei dem hier vorgestellten besonders bevorzugten Ausführungsbeispiel, bei dem für den Emitter eine separate Schicht aus Polysilizium vorhanden ist, kann durch Ausdiffusion aus diesem Polysilizium in den Emitterbereich unter Ausnutzung des Polyemitter-Effektes gezielt die Stromverstärkung nahezu unabhängig von den Dotierstoff-Profilen eingestellt werden.

Darüber hinaus bietet der erfindungsgemäße Bipolartransistor hervorragende Betriebseigenschaften, insbesondere eine kurze Basisweite für hohe Grenzfrequenz sowie eine hohe Early-Spannung. Die Basisweite dieses Bipolartransistors kann wegen des vertikalen Schichtaufbaus mittels Ionenimplantation exakt eingestellt werden, wie bei den bekannten High-Performance-Bipolar-Devices. Die zugehörige Technologie ist bei dem erfindungsgemäßen Bauelement ohne Einschränkung nutzbar.

Für Analog-Anwendungen ist eine hohe Early-Spannung der Bipolartransistoren wünschenswert. Diese kann nur mit moderat dotierten, relativ weiten Kollektorgebieten erreicht werden, in die sich bei angelegter Sperrspannung die Raumladungszone über eine große Distanz hin ausdehnen kann. Das ist bei dem erfindungsgemäßen Transistorkonzept durch die lange, lateral angeordnete Kollektorstrecke gewährleistet, die je nach Anforderung durch das jeweilige Design des Transistors gezielt eingestellt werden kann. Über die Dotierung des gesamten Kollektorbereichs 22 und ggf. eine zusätzliche Podest-Implantation des Kollektors unterhalb des Emitterbereiches kann das Bauelement hinsichtlich hoher Early-Spannungen oder hoher Stromergiebigkeit optimiert werden. Das erfindungsgemäße Bauelement ermöglicht daher besonders gute Performance bei gleichzeitig wesentlich vereinfachter Herstellbarkeit.

## Patentansprüche

1. Bipolartransistor in einer Body-Siliziumschicht (2) auf einer Isolationsschicht (1) eines SOI-Substrates,
bei dem diese Body-Siliziumschicht (2) eine Dicke von höchstens 1 um aufweist,
bei dem dieser Bipolartransistor bzgl. dieser Body-Siliziumschicht (2) vertikal übereinander einen für einen ersten Leitfähigkeitstyp dotierten Kollektorbereich (22), einen für den dazu entgegengesetzten zweiten Leitfähigkeitstyp dotierten Basisbereich (21) und einen für den ersten Leitfähigkeitstyp dotierten Emitterbereich (8) aufweist,
bei dem Kontakte (17, 18, 19) für Kollektor, Basis und Emitter vorhanden sind,
bei dem diese Kontakte jeweils mit diesem Kollektorbereich (22), mit diesem Basisbereich (21) bzw. mit diesem Emitterbereich (8) elektrisch leitend verbunden sind, und
bei dem dieser Kollektorbereich (22) auf der von diesem Basisbereich (21) abgewandten Seite von dieser Isolationsschicht (1) begrenzt ist,
**dadurch gekennzeichnet, daß** das Produkt aus dem Quadrat der Dicke des Kollektorbereichs (22) und der Dotierungsdichte des Kollektorbereichs (22) höchstens 8x10⁶ cm⁻¹ beträgt.

2. Bipolartransistor nach Anspruch 1,
bei dem die Dotierungshöhe des Kollektorbereiches (22) so niedrig ist, daß der Kollektorbereich (22) ohne angelegtes äußeres Potential im wesentlichen vollständig verarmt ist.

3. Bipolartransistor nach Anspruch 1 oder 2,
bei dem Anschlußbereiche (9, 10; 11, 12; 5) vorhanden sind, die die Kontakte jeweils mit dem Kollektorbereich (22), mit dem Basisbereich (21) bzw. mit dem Emitterbereich (8) elektrisch leitend verbinden, und
bei dem die Anschlußbereiche (9, 10; 11, 12) für Basis und Kollektor je einen mit einem Kontakt (17, 18) versehenen hoch dotierten Bereich (10, 12) und einen demgegenüber niedriger dotierten Übergangsbereich (9, 11) zwischen diesem hoch dotierten Bereich und dem Basisbereich bzw. dem Kollektorbereich umfassen.

4. Bipolartransistor nach einem der Ansprüche 1 bis 3,
mit mindestens einem in der Body-Siliziumschicht (2) integrierten MOSFET.

5. Bipolartransistor nach einem der Ansprüche 1 bis 3,
mit mindestens zwei in der Body-Siliziumschicht (2) integrierten, zueinander komplementären MOSFETs.

6. Bipolartransistor nach einem der Ansprüche 1 bis 5
mit mindestens einem weiteren in der Body-Siliziumschicht (2) integrierten und komplementären Bipolartransistor.

7. Bipolartransistor nach einem der Ansprüche 1 bis 6,
bei dem die Dicke der Body-Siliziumschicht (2) höchstens 0,4 µm beträgt.

8. Bipolartransistor nach einem der Ansprüche 1 bis 6,
bei dem die Dicke der Body-Siliziumschicht (2) höchstens 0,2 um beträgt.

9. Verfahren zur Herstellung eines Bipolartransistors nach einem der Ansprüche 1 bis 8, bei dem
in einem ersten Schritt in der Body-Siliziumschicht (2) eines SOI-Substrates ein für den Bipolartransistor vorgesehener Bereich ringsum elektrisch isoliert wird,
in einem zweiten Schritt unter Verwendung von Maskentechnik Implantierungen von Dotierstoff zur Ausbildung des Kollektorbereiches (22) und des Basisbereiches (21) erfolgen,
in einem dritten Schritt eine Dielektrikumschicht (3) aufgebracht und so strukturiert wird, daß ein Anteil des für den Basisbereich dotierten Bereiches freigelegt ist,
in einem vierten Schritt eine für einen Anschlußbereich (5) des Emitters vorgesehene Polysiliziumschicht aufgebracht und strukturiert wird,
in einem fünften Schritt nacheinander Implantationsmasken (7, 13) aufgebracht und entfernt werden und unter Verwendung dieser Implantationsmasken (7, 13) Implantierungen von Dotierstoff zur Ausbildung von Anschlußbereichen (5, 10, 12) erfolgen, wobei die Dotierungshöhe für den in dieser Polysiliziumschicht auszubildenden Anschlußbereich des Emitters so eingestellt wird, daß ein nachfolgender Temperschritt so vorgenommen werden kann, daß aus der Polysiliziumschicht in den für den Basisbereich dotierten Bereich ausdiffundierende Dotierstoffatome einen vorgesehenen Emitterbereich (8) bilden, und
in einem sechsten Schritt Kontakte (17, 18, 19) auf die Anschlußbereiche aufgebracht werden,
**dadurch gekennzeichnet, daß** der zweite Schritt so ausgeführt wird, daß das Produkt aus dem Quadrat der Dicke des Kollektorbereichs (22) und der Dotierungsdichte des Kollektorbereichs (22) höchstens 8x10⁶ cm⁻¹ beträgt.

10. Verfahren nach Anspruch 9, bei dem
zwischen dem dritten und dem vierten Schritt eine Podest-Implantierung zur Veränderung der Höhe der Dotierung des Kollektorbereichs (22) in dem Bereich, in dem in dem dritten Schritt die Dielektrikumschicht entfernt wurde, vorgenommen wird.

11. Verfahren nach Anspruch 9 oder 10 zur Herstellung eines Bipolartransistors nach einem der Ansprüche 4 oder 5, bei dem in dem ersten Schritt jeder für einen MOSFET vorgesehene Bereich ringsum elektrisch isoliert und jeweils ein Kanalbereich für das Gate hergestellt wird,
in dem dritten Schritt die Dielektrikumschicht als Oxidschicht (3) in einer für das Gate-Oxid der MOSFETs vorgesehenen Dicke aufgebracht wird,
in dem vierten Schritt die Polysiliziumschicht so strukturiert wird, daß sie in jedem für einen MOSFET vorgesehenen Bereich die Abmessung einer vorgesehenen Gate-Elektrode aufweist,
in dem fünften Schritt Source- und Drain-Bereiche und die Dotierung der Gate-Elektrode in jedem für einen MOSFET vorgesehenen Bereich hergestellt werden und
in dem sechsten Schritt Kontakte für den elektrischen Anschluß von Source, Drain und Gate jedes MOSFETs hergestellt werden.

12. Verfahren nach einem der Ansprüche 9 bis 11, bei dem zwischen dem vierten und dem fünften Schritt an Rändern der Polysiliziumschicht Spacer aufgebracht werden und
in dem fünften Schritt nach einer vorgenommenen Implantierung die freiliegenden Spacer entfernt und eine weitere Implantierung für denselben Leitfähigkeitstyp zur Herstellung von niedriger dotierten Übergangsbereichen vorgenommen wird.

## Claims

1. Bipolar transistor in a body silicon layer (2) on an insulation layer (1) of an SOI substrate,
in which the said body silicon layer (2) has a thickness of at most 1 µm,
in which the said bipolar transistor has, with regard to the said body silicon layer (2), vertically one above the other, a collector region (22) doped for a first conductivity type, a base region (21) doped for the second conductivity type opposite to said first conductivity type, and an emitter region (8) doped for the first conductivity type,
in which there are contacts (17, 18, 19) for collector, base and emitter,
in which the said contacts are electrically conductively connected respectively to the said collector region (22), to the said base region (21) and to the said emitter region (8), and
in which the said collector region (22) is bounded by the said insulation layer (1) on the side remote from the said base region (21),
**characterized in that** the product of the square of the thickness of the collector region (22) and the doping density of the collector region (22) is at most 8 x 10⁶ cm⁻¹.

2. Bipolar transistor according to Claim 1,
in which the doping level of the collector region (22) is so low that the collector region (22) is essentially completely depleted in the absence of an applied external potential.

3. Bipolar transistor according to Claim 1 or 2,
in which there are connection regions (9, 10; 11, 12; 5) which electrically conductively connect the contacts respectively to the collector region (22) to the base region (21) and to the emitter region (8), and
in which the connection regions (9, 10; 11, 12) for base and collector in each case comprise a highly doped region (10, 12) provided with a contact (17, 18), and, more lightly doped relative to the latter region, a junction region (9, 11) between the said highly doped region and the base region and the collector region, respectively.

4. Bipolar transistor according to one of Claims 1 to 3,
having at least one MOSFET integrated in the body silicon layer (2).

5. Bipolar transistor according to one of Claims 1 to 3,
having at least two, mutually complementary MOSFETs integrated in the body silicon layer (2).

6. Bipolar transistor according to one of Claims 1 to 5,
having at least one further complementary bipolar transistor integrated in the body silicon layer (2).

7. Bipolar transistor according to one of Claims 1 to 6,
in which the thickness of the body silicon layer (2) is at most 0.4 µm.

8. Bipolar transistor according to one of Claims 1 to 6,
in which the thickness of the body silicon layer (2) is at most 0.2 µm.

9. Method for fabricating a bipolar transistor according to one of Claims 1 to 8, in which
in a first step, in the body silicon layer (2) of an SOI substrate, a region provided for the bipolar transistor is electrically insulated all around,
in a second step, using mask technology, implantations of dopant are effected in order to form the collector region (22) and the base region (21),
in a third step, a dielectric layer (3) is applied and patterned in such a way that a portion of the region doped for the base region is uncovered,
in a fourth step, a polysilicon layer provided for a connection region (5) of the emitter is applied and patterned,
in a fifth step, implantation masks (7, 13) are successively applied and removed and, using these implantation masks (7, 13), implantations of dopant are effected in order to form connection regions (5, 10, 12), the doping level for the emitter's connection region to be formed in the said polysilicon layer being set in such a way that a subsequent heat-treatment step can be performed in such a way that dopant atoms diffusing from the polysilicon layer into the region doped for the base region form an envisaged emitter region (8), and
in a sixth step, contacts (17, 18, 19) are applied to the connection regions,
**characterized in that** the second step is carried out in such a way that the product of the square of the thickness of the collector region (22) and the doping density of the collector region (22) is at most 8 x 10⁶ cm⁻¹.

10. Method according to Claim 9, in which
between the third and fourth steps, a pedestal implantation is performed in order to alter the level of the doping of the collector region (22) in the region in which the dielectric layer was removed in the third step.

11. Method according to Claim 9 or 10 for fabricating a bipolar transistor according to either of Claims 4 and 5, in which
in the first step, each region provided for a MOSFET is electrically insulated all around and a channel region for the gate is fabricated in each case,
in the third step, the dielectric layer is applied as an oxide layer (3) to a thickness envisaged for the gate oxide of the MOSFETs,
in the fourth step, the polysilicon layer is patterned in such a way that it has the dimensioning of an envisaged gate electrode in each region provided for a MOSFET,
in the fifth step, source and drain regions and the doping of the gate electrode are fabricated in each region provided for a MOSFET, and
in the sixth step, contacts for the electrical connection of source, drain and gate of each MOSFET are fabricated.

12. Method according to one of Claims 9 to 11, in which
between the fourth and fifth steps, spacers are applied on edges of the polysilicon layer, and
in the fifth step, after an implantation has been performed, the uncovered spacers are removed and a further implantation for the same conductivity type is performed in order to fabricate more lightly doped junction regions.

## Revendications

1. Transistor bipolaire dans une couche (2) de silicium body sur une couche (3) d'isolement d'un substrat en SOI,
dans lequel cette couche (2) de silicium body a une épaisseur de 1 µm au plus,
dans lequel ce transistor bipolaire ou cette couche (2) de silicium body comporte, verticalement superposées, une zone (22) de collecteur dopée pour un premier type de conductivité, une zone (21) de base dopée pour un deuxième type de conductivité opposée au premier type et une zone (8) d'émetteur dopée pour le premier type de conductivité,
dans lequel il est prévu des contacts (17, 18, 19) pour le collecteur, la base et l'émetteur,
dans lequel ces contacts sont reliés de manière conductrice de l'électricité respectivement à cette zone (22) de collecteur, à cette zone (21) de base et à cette zone (8) d'émetteur et
dans lequel cette zone (22) de collecteur est délimitée du côté éloigné de cette zone (21) de base par cette couche (1) d'isolement,
**caractérisé en ce que** le produit du carré de l'épaisseur de la zone (22) de collecteur par la densité de dopage de la zone (22) de collecteur est au plus égal à 8 x 10⁶ cm⁻¹.

2. Transistor bipolaire suivant la revendication 1,
dans lequel le niveau de dopage de la zone (22) de collecteur est si bas que la zone (22) de collecteur est sensiblement entièrement appauvrie sans application d'un potentiel extérieur.

3. Transistor bipolaire suivant la revendication 1 ou 2,
dans lequel il est prévu des zones (9, 10 ; 11, 12 ; 5) de borne, qui relient d'une manière électriquement conductrice les contacts respectivement à la zone (22) de collecteur, à la zone (21) de base et à la zone (8) d'émetteur et
dans lequel les zones (9, 10 ; 11, 12) de borne pour la base et le collecteur comprennent respectivement une zone (10, 12) très dopée munie d'un contact (17, 18) et une zone (9, 11) de jonction faiblement dopée par rapport à la zone très dopée entre cette zone très dopée et la zone de base ou la zone de collecteur.

4. Transistor bipolaire suivant l'une des revendications 1 à 3, comprenant au moins un MOSFET intégré dans la couche (2) de silicium body.

5. Transistor bipolaire suivant l'une des revendications 1 à 3, comprenant au moins deux MOSFET complémentaires l'un dé l'autre intégrés dans la couche (2) de silicium body.

6. Transistor bipolaire suivant l'une des revendications 1 à 5, comprenant au moins un autre transistor intégré et complémentaire dans la couche (2) de silicium body.

7. Transistor bipolaire suivant l'une des revendications 1 à 6, dans lequel l'épaisseur de la couche (2) de silicium body est au plus de 0,4 µm.

8. Transistor bipolaire suivant l'une des revendications 1 à 6, dans lequel l'épaisseur de la couche (2) de silicium body est au plus de 0,2 µm.

9. Procédé de fabrication d'un transistor bipolaire suivant l'une des revendications 1 à 8, dans lequel
dans un premier stade on isole électriquement tout autour dans la couche (2) de silicium body d'un substrat en SOI une zone prévue pour le transistor bipolaire,
dans un deuxième stade on effectue en utilisant la technique de masque, des implantations de substance de dopage pour constituer la zone (22) de collecteur et la zone (21) de base,
dans un troisième stade on dépose une couche (3) de diélectrique et on la structure de manière à mettre à nu une partie de la zone dopée pour la zone de base,
dans un quatrième stade on dépose et on structure une couche de polysilicium prévue pour une zone (5) de borne de l'émetteur,
dans un cinquième stade on dépose l'un après l'autre des masques (7, 13) d'implantation et on les élimine et on effectue en utilisant ces masques (7, 13) d'implantation des implantations de substance de dopage pour constituer des zones (5, 10, 12) de borne, le niveau de dopage pour la zone de borne de l'émetteur à constituer dans cette couche de polysilicium étant réglé de manière à pouvoir effectuer un stade de traitement thermique ultérieur, de sorte qu'il se forme à partir des atomes de la substance de dopage qui diffusent de la couche de polysilicium dans la zone dopée pour la zone de base, une zone (8) d'émetteur prévu et
dans un sixième stade on dépose des contacts (17, 18, 19) sur les zones de borne
**caractérisé en ce que** l'on effectue le deuxième stade de façon que le produit du carré de l'épaisseur de la zone (22) de collecteur par la densité de dopage de la zone (22) de collecteur soit au plus de 8 x 10⁶ cm⁻¹.

10. Procédé suivant la revendication 9, dans lequel on effectue entre le troisième et le quatrième stade une implantation podest pour modifier le niveau de dopage de la zone (22) de collecteur, dans la zone dans laquelle la couche de diélectrique a été éliminée au troisième stade.

11. Procédé suivant la revendication 9 ou 10 pour la fabrication d'un transistor bipolaire suivant l'une des revendications 4 ou 5, dans lequel on isole électriquement tout autour dans le premier stade chaque zone prévue pour un MOSFET et on fabrique respectivement une zone de canal pour la grille,
on dépose dans le troisième stade la couche diélectrique sous la forme d'une couche (3) d'oxyde en une épaisseur prévue pour l'oxyde de grille des MOSFETs,
on structure dans le quatrième stade la couche de polysilicium de façon à ce qu'elle ait dans chacune des zones prévues pour un MOSFET la dimension d'une électrode de grille qui est prévue,
on fabrique dans le cinquième stade des zones de source et de drain et le dopage de l'électrode de grille dans chaque zone prévue pour un MOSFET et
on fabrique dans le sixième stade des contacts pour le raccordement électrique de la source du drain et de la grille de chaque

12. Procédé suivant l'une des revendications 9 à 11, dans lequel entre le quatrième et le cinquième stade on dépose sur les bords de la couche de polysilicium des espaceurs et
dans le cinquième stade on élimine; après avoir effectué une implantation, les espaceurs mis à nu et on effectue une autre implantation pour le même type de conductivité pour fabriquer des zones de jonction faiblement dopées.
